# EUROPÄISCHE PATENTSCHRIFT

(11) **EP 3 876 355 B1**
(45) Veröffentlichungstag und Bekanntmachung des Hinweises auf die Patenterteilung: **30.08.2023**
(21) Anmeldenummer: 21160104.2
(22) Anmeldetag: 02.03.2021
(51) Int. Cl.: H01R 9/26, H05K 7/14

(54) **ANSCHLUSSVORRICHTUNG UND ELEKTROMECHANISCHE BAUGRUPPE**
CONNECTION DEVICE AND ELECTROMECHANICAL ASSEMBLY
DISPOSITIF DE CONNEXION ET MODULE ÉLECTROMÉCANIQUE

(30) Priorität: 06.03.2020 DE 102020106085
(43) Veröffentlichungstag der Anmeldung: 08.09.2021
(73) Patentinhaber: Phoenix Contact GmbH & Co. KG, 32825 Blomberg (DE)
(72) Erfinder: ANDRESEN, Jens, 32825 Blomberg (DE); REIBKE, Heinz, 32105 Bad Salzuflen (DE)

(56) Entgegenhaltungen:
- EP-A1- 3 484 253
- EP-A2- 0 236 711
- EP-A2- 0 709 933
- WO-A1-2019/025139
- DE-U1-202011 105 337
- DE-U1-202013 003 925

## Beschreibung

Die vorliegende Erfindung betrifft eine Anschlussvorrichtung mit einem Kontaktfeld zur Befestigung und Kontaktierung elektronischer Geräte und mit einem Adapter zur Aufnahme elektromechanischer Komponenten, wobei das Kontaktfeld mindestens eine Stromschiene hat, wobei die Stromschiene in einem Kunststoffgehäuse des Kontaktfelds aufgenommen ist, wobei das Kunststoffgehäuse eine Mehrzahl von ersten Durchgangsöffnungen und zweiten Durchgangsöffnungen hat, wobei die ersten Durchgangsöffnungen dazu eingerichtet sind, Kontakte elektronischer Geräte durchzustecken, um die elektronischen Geräte in einem an dem Kontaktfeld montierten Zustand elektrisch leitend mit der Stromschiene zu verbinden, wobei an dem Kontaktfeld der Adapter befestigt ist. Weiter betrifft die Erfindung eine elektromechanische Baugruppe mit einer solchen Anschlussvorrichtung.

Eine entsprechende Anschlussvorrichtung ist beispielsweise aus der EP 0 709 933 A2, der US 10 194 553 B1 oder der DE 20 2011 105 337 U1 bekannt.

Um den Montageaufwand bei der Bestückung von Schaltschränken oder der Ausstattung von Maschinen und Anlagen mit elektronischen Geräten zur Einspeisung, Verteilung, Transformation, Steuerung und Absicherung elektrischer Leistung zu reduzieren, ist es bekannt, modulare Systeme einzusetzen. Ein solches modulares System ist die eingangs genannte Anschlussvorrichtung, deren Kontaktfeld individuell mit elektronischen Geräten bestückt werden kann. Diese elektronischen Geräte müssen häufig ihrerseits mit weiteren elektromechanischen Komponenten verbunden werden, die nicht an dem Kontaktfeld selbst montierbar sind.

So entsteht zwar eine Zeitersparnis, indem eine Mehrzahl elektronischer Geräte auf dem Kontaktfeld vormontiert und anschließend als eine Einheit in einem Schaltschrank, einer Maschine oder einer Anlage montiert werden können. Die weitere Einbindung dieser elektronischen Geräte in einen Schaltschrank, eine Maschine oder Anlage erfordert jedoch einen erhöhten Zeitaufwand, da einzelne elektromechanische Komponenten weiterhin separat von dem Kontaktfeld montiert und mit den entsprechenden elektronischen Geräten verkabelt werden müssen. Dabei ist zudem nachteilig, dass die Funktionsprüfung der elektronischen Geräte im Zusammenwirken mit den elektromechanischen Komponenten erst im fertig montierten Zustand erfolgen kann.

Der Erfindung liegt daher die Aufgabe zu Grunde, eine Anschlussvorrichtung und eine elektromechanische Baugruppe zur Verfügung zu stellen, welche eine vereinfachte Montage und Prüfung, insbesondere eine Vormontage und Prüfung außerhalb eines Schaltschranks, ermöglichen.

Die Aufgabe wird erfindungsgemäß mit den Merkmalen der unabhängigen Ansprüche gelöst. Zweckmäßige Ausgestaltungen und vorteilhafte Weiterbildungen der Erfindung sind in den Unteransprüchen angegeben.

Gemäß der Erfindung wird eine Anschlussvorrichtung angegeben, mit einem Kontaktfeld zur Befestigung und Kontaktierung elektronischer Geräte und mit einem Adapter zur Aufnahme elektromechanischer Komponenten, wobei das Kontaktfeld mindestens eine Stromschiene hat, wobei die Stromschiene in einem Kunststoffgehäuse des Kontaktfelds aufgenommen ist, wobei das Kunststoffgehäuse eine Mehrzahl von ersten Durchgangsöffnungen und zweiten Durchgangsöffnungen hat, wobei die ersten Durchgangsöffnungen dazu eingerichtet sind, Kontakte elektronischer Geräte durchzustecken, um die elektronischen Geräte in einem an dem Kontaktfeld montierten Zustand elektrisch leitend mit der Stromschiene zu verbinden, wobei die zweiten Durchgangsöffnungen dazu eingerichtet sind, Befestigungselemente elektronischer Geräte aufzunehmen, um die elektronischen Geräte lösbar mit dem Kontaktfeld zu verbinden. An dem Kontaktfeld ist erfindungsgemäß der Adapter befestigt, wobei der Adapter einen Kunststoff aufweist oder wobei der Adapter aus einem Kunststoff besteht, wobei der Adapter keine elektrisch leitenden Elemente zum Kontaktieren und/oder Verbinden elektromechanischer Komponenten oder elektronischer Geräte aufweist, und wobei der Adapter zum Befestigen von Klemmenblöcken eingerichtet ist.

Der Adapter ermöglicht insbesondere eine Befestigung elektromechanischer Komponenten in der Nähe der elektronischen Geräte bzw. benachbart zu den elektronischen Geräten, so dass das Kontaktfeld zusammen mit dem Adapter als Einheit in einem Schaltschrank, einer Anlage oder Maschine montierbar und vorab mit elektronischen Geräten und/oder elektromechanischen Komponenten bestückbar ist. Insbesondere können elektronische Geräte und/oder elektromechanische Komponenten vormontiert und vor der Montage als Funktionsbaugruppe geprüft werden. Der Adapter ist flexibel an verschiedenen Seiten des Kontaktfeldes nachträglich adaptierbar bzw. anordbar, wodurch eine Funktionsbaugruppe mit weiteren elektronischen/elektrotechnischen Komponenten gebaut werden kann.

Auf diese Weise ermöglicht die Anschlussvorrichtung eine Zeitersparnis, da elektronische Geräte und/oder elektromechanische Komponenten vormoniert, schnell verbunden und geprüft werden können, bevor diese in einem Schaltschrank, einer Anlage oder Maschine montiert werden. Zudem können durch die kompakte Anordnung Leitungslängen zum Verbinden elektronischer Geräte mit elektromechanischen Komponenten verkürzt werden.

Es kann vorgesehen sein, dass elektromechanische Komponenten und/oder elektronische Geräte werkzeuglos steckbar und werkzeuglos mit dem Adapter bzw. dem Kontaktfeld verrastbar sind, so dass die Montagezeit weiter reduziert werden kann.

Wenn vorliegend von elektronischen Geräten gesprochen wird, so handelt es sich dabei insbesondere um Geräte zur Einspeisung, Verteilung, Transformation, Steuerung und Absicherung elektrischer Leistung, wie Einspeisemodule zum Anlegen einer Versorgungsspannung; Netzteilmodule zur Spannungsversorgung einer oder mehrerer Steuerungen; Leitungsschutzschalter, Motorstarter oder Phasenwächter; Motorstarter; Schalter für ohmsche Verbraucher; Lasttrennschalter oder dergleichen.

Wenn vorliegend von elektromechanischen Komponenten gesprochen wird, so handelt es sich dabei um Klemmenblöcke. Ein Klemmenblock kann z.B. ein Verteilerblock mit einer Mehrzahl von Push-In oder Schraubklemmenanschlüssen zur Befestigung elektrischer Leiter sein.

Das Kontaktfeld kann genau drei Stromschienen haben. Die Stromschienen können im Wesentlichen parallel und unter einem Abstand zueinander angeordnet sein.

Erfindungsgemäß ist es vorgesehen, dass der Adapter einen Kunststoff aufweist oder dass der Adapter aus einem Kunststoff besteht, wobei der Adapter keine elektrisch leitenden Elemente zum Kontaktieren und/oder Verbinden elektromechanischer Komponenten oder elektronischer Geräte aufweist. Der Adapter dient daher in diesem Fall der reinen mechanischen Befestigung elektromechanischer Komponenten, ohne eine elektrische Leistung oder elektrische Signale zu übertragen.

Der Adapter ist rein mechanischer Adapter. Der Adapter kann auch ein Metallmaterial aufweisen.

Das Kontaktfeld kann eine Bestückungsebene haben, im Bereich derer elektronische Geräte oder elektromechanische Einspeisekomponenten an dem Kontaktfeld angeordnet werden, wobei das Kontaktfeld eine Befestigungsseite hat, im Bereich derer das Kontaktfeld mit einem Schaltschrank oder einer das Kontaktfeld tragenden Struktur verbindbar ist, wobei die Befestigungsseite der Bestückungsebene abgewandt ist und wobei der Adapter zumindest abschnittsweise im Bereich einer zwischen der Befestigungsseite und der Bestückungsebene angeordneten Randseite des Kontaktfelds angeordnet ist. Insbesondere kann der Adapter daher seitlich und unter einem seitlichen Abstand zur Bestückungsebene angeordnet sein, so dass der Adapter eine zur Verfügung stehende Montagefläche der Bestückungsebene nicht reduziert. Es steht daher mit oder ohne den Adapter die gleiche Montagefläche zur Anbringung elektronischer Geräte an dem Kontaktfeld zur Verfügung.

Insbesondere kann der Adapter derart an dem Kontaktfeld befestigt sein, dass der Adapter keine der ersten und zweiten Durchgangsöffnungen im Bereich der Bestückungsebene überdeckt. Mit anderen Worten sind alle ersten und zweiten Durchgansöffnungen im Bereich der Bestückungsebene frei zugänglich.

Der Adapter kann gegenüber der Bestückungsebene des Kontaktfelds zurückversetzt angeordnet sein, wobei eine Bestückungsebene des Adapters entlang einer Einsteckrichtung zur Montage elektronische Geräte und/oder elektromechanischer Komponenten betrachtet einen Abstand zu der Bestückungsebene des Kontaktfelds aufweist. Die Einsteckrichtung kann insbesondere orthogonal zur Bestückungsebene des Kontaktfelds orientiert sein. Durch die gegenüber der Bestückungsebene zurückversetzte Anordnung des Adapters kann vermieden werden, dass an dem Adapter zu befestigende Komponenten, wie Verteilerblöcke oder dergleichen, Anschluss- oder Funktionsbereiche der an dem Kontaktfeld zu montierenden elektronischen Geräte überdecken und den Zugang dazu erschweren oder unmöglich machen.

Der Adapter kann mit dem Kontaktfeld mechanisch verrastet sein. Insbesondere kann der Adapter mit dem Kontaktfeld lösbar verbunden sein, um eine einfache Montage und Demontage des Adapters an dem Kontaktfeld zu ermöglichen. Beispielsweise kann der Adapter form- und/oder kraftschlüssig mit dem Kontaktfeld verbunden sein.

Das Kontaktfeld kann ein Profil zum Befestigen des Kontaktfelds an einer Hutschiene aufweisen, insbesondere ein Profil zum Befestigen des Kontaktfelds an einer DIN-Tragschiene aufweisen, wie sie z.B. im Schaltschrankbau verwendet wird (z.B. DIN EN 60715:2018-07).

Es kann vorgesehen sein, dass dem Profil ein federnd elastisch vorgespannter Rastmechanismus zugeordnet ist, um das Profil mit einer Hutschiene bzw. Tragschiene zu verrasten, wobei der Rastmechanismus eines oder mehrere bewegliche, federbeaufschlagte Klemmelemente haben kann, die an wenigstens einem auskragenden Steg der Hutschiene anliegen können, um das Kontaktfeld formschlüssig an der Hutschiene bzw. der Tragschiene festzulegen.

Der Adapter ist erfindungsgemäß zum Befestigen von Klemmenblöcken eingerichtet. Ein solcher Klemmenblock kann ein Verteilerblock sein, wie z.B. ein Verteilerblock der Produktreihe PTFIX der Firma Phoenix Contact.

Es kann vorgesehen sein, dass ein Rastermaß der Durchgangsöffnungen 4,5 mm beträgt. Die ersten und zweiten Durchgangsöffnung können demnach zu benachbarten Durchgangsöffnungen einen Abstand von 4,5 mm aufweisen, wobei der Abstand insbesondere von einer Mitte einer ersten Durchgangsöffnung bis zu einer Mitte einer benachbarten Durchgangsöffnung gemessen wird. So können elektronische Geräte mit standardisierten Gehäusen, Kontakt- und Befestigungselementen verwendet werden, die mit dem Kontaktfeld koppelbar sind.

Weiter betrifft die Erfindung eine elektromechanische Baugruppe, mit einer erfindungsgemäßem Anschlussvorrichtung, wobei an dem Kontaktfeld eines oder mehrere der nachfolgend genannten elektronischen Geräte befestigt sind: Einspeisemodul zum Anlegen einer Versorgungsspannung; Netzteilmodul zur Spannungsversorgung einer oder mehrerer Steuerungen; DIN-Tragschienenadapter zum Aufnehmen eines Leitungsschutzschalters, Motorstarters oder Phasenwächters; Motorstarter; Schalter für ohmsche Verbraucher; Lasttrennschalter; und wobei an dem Adapter ein oder mehrere Klemmenblöcke befestigt sind.

Es kann vorgesehen sein, dass wenigstens eine elektromechanische Komponente mit wenigstens einem elektronischen Gerät elektrisch leitend verbunden ist, insbesondere über eine Kabel- oder Leitungsverbindung.

Es kann vorgesehen sein, dass der Adapter im fertig montierten Zustand der elektromechanische Baugruppe, d.h. zum Beispiel in einem Schaltschrank, einer Maschine oder einer Anlage, ausschließlich an dem Kontaktfeld befestigt ist. Demnach kann der Adapter ein reines Anbauteil zur Ergänzung des Kontaktfelds sein, dass ausschließlich am dem Kontaktfeld gehalten ist.

Es können demnach ein Schaltschrank, eine Maschine oder eine Anlage angegeben werden, mit einer erfindungsgemäßen Anschlussvorrichtung und/oder einer erfindungsgemäßen elektromechanischen Baugruppe, wobei ein Adapter der Anschlussvorrichtung und/oder der elektromechanischen Baugruppe ausschließlich an dem Kontaktfeld befestigt ist und nicht unmittelbar mit einem Strukturbauteil des Schaltschranks, der Maschine oder der Anlage verbunden ist.

Nachfolgend wird die Erfindung unter Bezugnahme auf die anliegenden Zeichnungen anhand bevorzugter Ausführungsformen näher erläutert.

Es zeigen
- Fig. 1: eine schematische Darstellung einer elektromechanischen Baugruppe der Erfindung in einer perspektivischen Ansicht;
- Fig. 2: eine schematische Darstellung der elektromechanischen Baugruppe aus Fig. 1 in einer Frontansicht;
- Fig. 3: eine schematische Darstellung der elektromechanischen Baugruppe aus Fig. 1 in einer Seitenansicht.

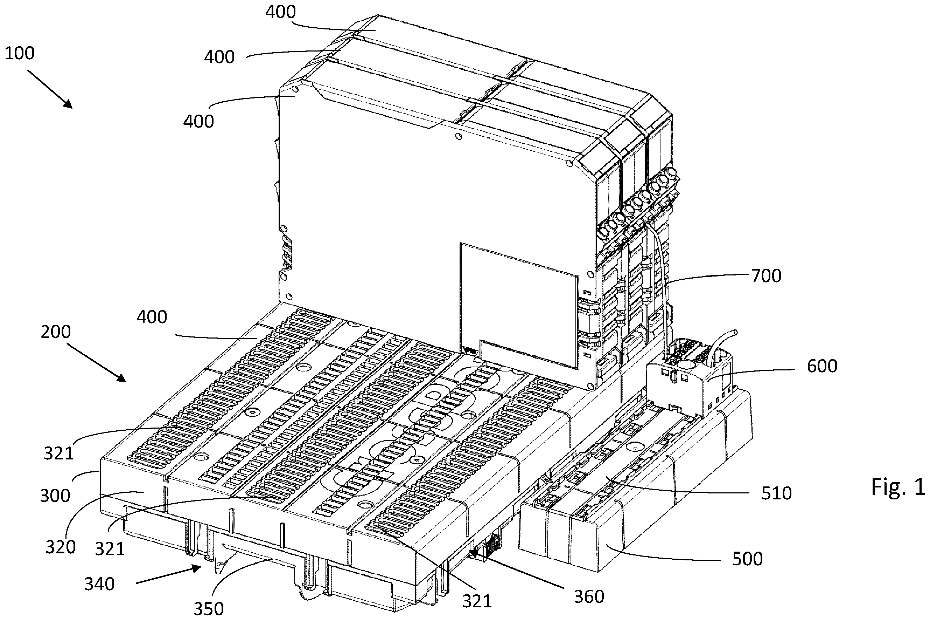

Fig. 1 zeigt eine erfindungsgemäße elektromechanische Baugruppe 100. Die elektromechanische Baugruppe 100 hat eine erfindungsgemäße Anschlussvorrichtung 200. Die Anschlussvorrichtung 200 hat ein Kontaktfeld 300, an dem drei elektronische Geräte 400 befestigt sind. Die Anschlussvorrichtung 200, hat zudem einen Adapter 500, an dem eine elektromechanische Komponente 600 befestigt ist.

Das Kontaktfeld 300 der Anschlussvorrichtung 200 dient der Befestigung und Kontaktierung der elektronischen Geräte 400.

Das Kontaktfeld 300 hat vorliegend drei Stromschienen 310, die in einem Kunststoffgehäuse 320 des Kontaktfelds 300 aufgenommen sind. Die Stromschienen 310 sind parallel und unter einem Abstand zu einander angeordnet.

Das Kunststoffgehäuse 320 des Kontaktfelds 300 hat eine Mehrzahl von ersten Durchgangsöffnungen 321 und eine Mehrzahl von zweiten Durchgangsöffnungen 322.

Die ersten Durchgangsöffnungen 321 sind dazu eingerichtet, Kontakte elektronischer Geräte 400 durchzustecken, um die elektronischen Geräte 400 in einem an dem Kontaktfeld 300 montierten Zustand elektrisch leitend mit den Stromschienen 310 zu verbinden. Demnach sind die Stromschienen 310 unmittelbar hinter den Durchgangsöffnungen 321 des Kunststoffgehäuses 300 angeordnet.

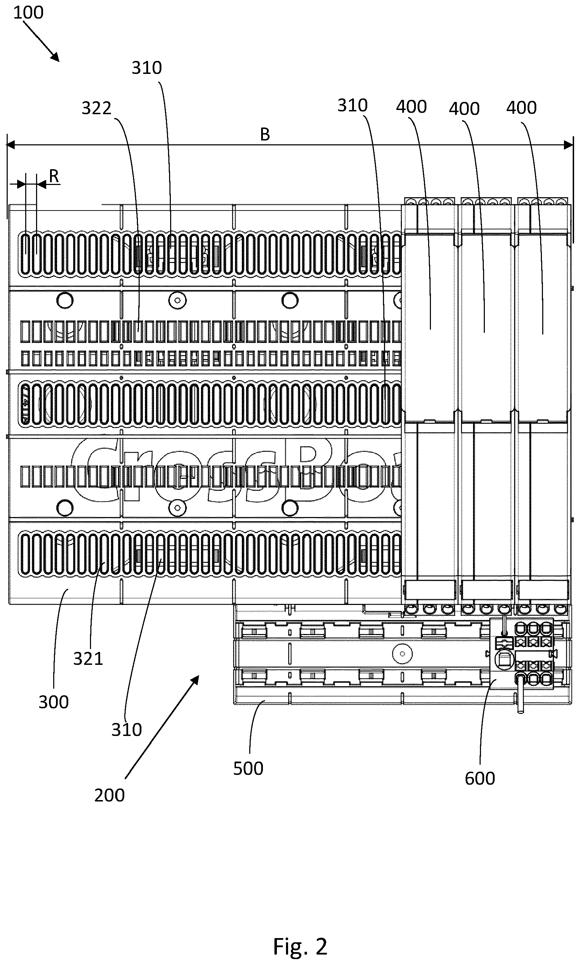

Die Stromschienen 310 erstrecken sich entsprechend der dreireihigen Anordnung der Durchgangsöffnungen 321 entsprechend jeweils über eine Breite B des Kontaktfelds 300 (Fig. 2).

Die zweiten Durchgangsöffnungen 322 dienen dazu, Befestigungselemente, wie Rasthaken oder dergleichen, die an elektronischen Geräten 400 angeordnet sind, aufzunehmen, um die elektronischen Geräte 400 lösbar mit dem Kontaktfeld 300 zu verbinden. Die elektronischen Geräte 400 können dabei beispielsweise werkzeuglos mit dem Kontaktfeld 300 verbunden werden, indem Befestigungselemente elektronischer Geräte 400 mit dem Kunststoffgehäuse 320 des Kontaktfelds 300 verrastet werden, wobei beispielsweise Rasthaken elektronischer Geräte 400 die zweiten Durchgangsöffnungen 322 durchdringen und in das Kunststoffgehäuse 320 eingreifen.

An dem Kontaktfeld 300 ist der Adapter 500 zur Aufnahme elektromechanischer Komponenten 600 befestigt.

Der Adapter 500 besteht vorliegend aus einem Kunststoff und weist keine elektrisch leitenden Elemente zum Kontaktieren und/oder Verbinden elektromechanischer Komponenten 600 oder elektronischer Geräte 400 auf. Der Adapter 500 dient daher ausschließlich der mechanischen Befestigung elektromechanischer Komponenten 600 benachbart zu bzw. in der Nähe von elektronischen Geräten 400, die an dem Kontaktfeld 300 gehalten sind.

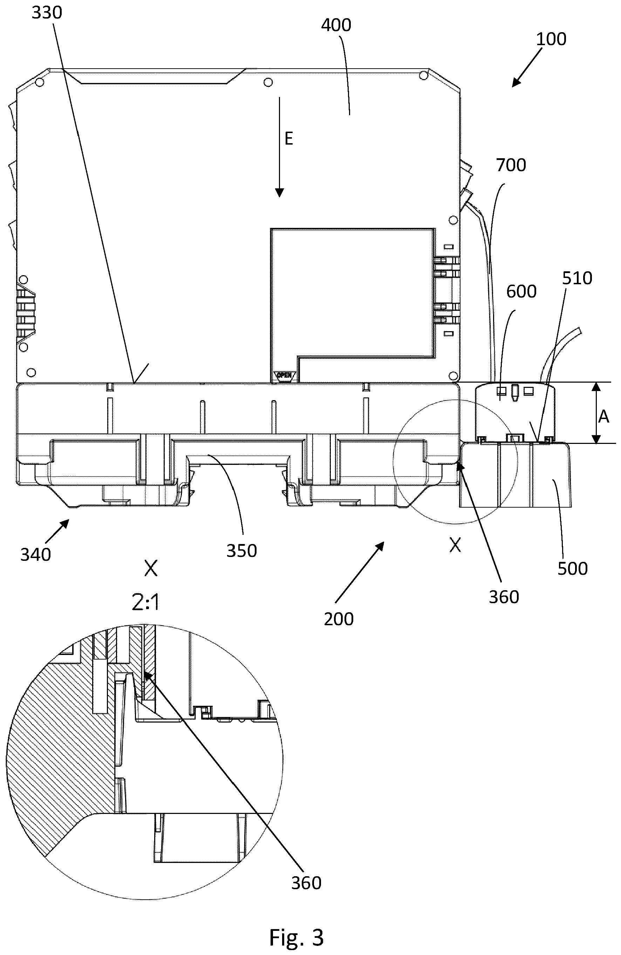

Das Kontaktfeld 300 hat eine Bestückungsebene 330, im Bereich derer die elektronischen Geräte 400 an dem Kontaktfeld 300 anliegen (Fig. 3). Das Kontaktfeld 300 hat weiter eine Befestigungsseite 340, im Bereich derer das Kontaktfeld 300 mit einem Schaltschrank oder einer das Kontaktfeld 300 tragenden Struktur eines Schaltschranks, eine Maschine oder eine Anlage verbindbar ist. Die Befestigungsseite 340 ist der Bestückungsebene 330 abgewandt.

Der Adapter 500 ist zumindest abschnittsweise im Bereich einer zwischen der Befestigungsseite 340 und der Bestückungsebene 330 angeordneten Randseite 360 des Kontaktfelds 300 angeordnet.

Der Adapter 500 ist gegenüber der Bestückungsebene 330 des Kontaktfelds 300 zurückversetzt angeordnet, wobei eine Bestückungsebene 510 des Adapters 500 entlang einer Einsteckrichtung E zur Montage elektronischer Geräte 400 und/oder elektromechanischer Komponenten 600 betrachtet einen Abstand A zu der Bestückungsebene 330 des Kontaktfelds 300 aufweist. Auf diese Weise wird gewährleistet, dass die an dem Adapter 500 befestigte elektromechanische Komponente 600 den Zugang zu dem elektronischen Gerät 400 nicht einschränkt, da die elektromechanische Komponente 600 das elektronische Gerät 400 nicht überdeckt.

Das Kontaktfeld 300 weist im Bereich der Befestigungsseite 340 ein Profil 350 auf, um das Kontaktfeld 300 an einer Hutschiene oder dergleichen zu befestigen. Demnach ist die gesamte elektromechanische Baugruppe 100 vormontierbar und kann als Einheit verbaut werden, wobei einzig die Befestigung des Kontaktfelds 300 ein einer tragenden Struktur erforderlich ist und das Kontaktfeld 300 seinerseits alle weiteren Komponenten der elektromechanischen Baugruppe 100 trägt.

Bei der elektromechanischen Komponente 600 handelt es sich vorliegend um einen Klemmenblock 600.

Ein Rastermaß R der Durchgangsöffnungen 321, 322 beträgt vorliegend 4,5 mm.

Die elektromechanische Komponente 600 ist mithilfe einer Kabel- oder Leitungsverbindung 700 mit einem elektronischen Gerät 400 elektrisch leitend verbunden.

### Bezugszeichenliste

- 100: elektromechanische Baugruppe
- 200: Anschlussvorrichtung
- 300: Kontaktfeld
- 310: Stromschiene
- 320: Kunststoffgehäuse
- 321: erste Durchgangsöffnung
- 322: zweite Durchgangsöffnung
- 330: Bestückungsebene
- 340: Befestigungsseite
- 350: Profil
- 360: Randseite
- 400: elektronisches Gerät
- 500: Adapter
- 510: Bestückungsebene
- 600: elektromechanische Komponente
- 700: Kabel- oder Leitungsverbindung

## Patentansprüche

1. Anschlussvorrichtung (200), mit einem Kontaktfeld (300) zur Befestigung und Kontaktierung elektronischer Geräte (400) und mit einem Adapter (500) zur Aufnahme elektromechanischer Komponenten (600), wobei das Kontaktfeld (300) mindestens eine Stromschiene (310) hat, wobei die Stromschiene (310) in einem Kunststoffgehäuse (320) des Kontaktfelds (300) aufgenommen ist, wobei das Kunststoffgehäuse (320) eine Mehrzahl von ersten Durchgangsöffnungen (321) und zweiten Durchgangsöffnungen (322) hat, wobei die ersten Durchgangsöffnungen (321) dazu eingerichtet sind, Kontakte elektronischer Geräte (400) durchzustecken, um die elektronischen Geräte (400) in einem an dem Kontaktfeld (300) montierten Zustand elektrisch leitend mit der Stromschiene (310) zu verbinden, wobei an dem Kontaktfeld (300) der Adapter (500) befestigt ist, **dadurch gekennzeichnet, dass** die zweiten Durchgangsöffnungen (322) dazu eingerichtet sind, Befestigungselemente elektronischer Geräte (400) aufzunehmen, um die elektronischen Geräte (400) lösbar mit dem Kontaktfeld (300) zu verbinden, wobei der Adapter (500) einen Kunststoff aufweist oder wobei der Adapter (500) aus einem Kunststoff besteht, wobei der Adapter (500) keine elektrisch leitenden Elemente zum Kontaktieren und/oder Verbinden elektromechanischer Komponenten (600) oder elektronischer Geräte (400) aufweist, und wobei der Adapter (500) zum Befestigen von Klemmenblöcken (600) eingerichtet ist.

2. Anschlussvorrichtung nach Anspruch 1, **dadurch gekennzeichnet, dass** das Kontaktfeld (300) eine Bestückungsebene (330) hat, im Bereich derer elektronische Geräte (400) an dem Kontaktfeld (300) angeordnet werden, dass das Kontaktfeld (300) eine Befestigungsseite (340) hat, im Bereich derer das Kontaktfeld (300) mit einem Schaltschrank oder einer das Kontaktfeld (300) tragenden Struktur verbindbar ist, wobei die Befestigungsseite (340) der Bestückungsebene (330) abgewandt ist, und dass der Adapter (500) zumindest abschnittsweise im Bereich einer zwischen der Befestigungsseite (340) und der Bestückungsebene (330) angeordneten Randseite (360) des Kontaktfelds (300) angeordnet ist.

3. Anschlussvorrichtung nach Anspruch 1, **dadurch gekennzeichnet, dass** der Adapter (500) gegenüber der Bestückungsebene (330) des Kontaktfelds (300) zurückversetzt angeordnet ist, wobei eine Bestückungsebene (510) des Adapters (500) entlang einer Einsteckrichtung (E) zur Montage elektronischer Geräte (400) und/oder elektromechanischer Komponenten (600) betrachtet einen Abstand (A) zu der Bestückungsebene (330) des Kontaktfelds (300) aufweist.

4. Anschlussvorrichtung nach einem der Ansprüche 1 bis 3, **dadurch gekennzeichnet, dass** der Adapter (500) mit dem Kontaktfeld (300) mechanisch verrastet ist.

5. Anschlussvorrichtung nach einem der Ansprüche 1 bis 4, **dadurch gekennzeichnet, dass** das Kontaktfeld (300) ein Profil (350) zum Befestigen des Kontaktfelds (300) an einer Hutschiene aufweist.

6. Anschlussvorrichtung nach einem der Ansprüche 1 bis 5, **dadurch gekennzeichnet, dass** ein Rastermaß (R) der Durchgangsöffnungen (321, 322) 4,5 mm beträgt.

7. Elektromechanische Baugruppe (100), mit einer Anschlussvorrichtung (200) nach einem der voranstehenden Ansprüche 1 bis 6, mit einem oder mehreren der nachfolgend genannten elektronischen Geräte (400), welche an dem Kontaktfeld (300) befestigt sind: Einspeisemodul zum Anlegen einer Versorgungsspannung; Netzteilmodul zur Spannungsversorgung einer oder mehrerer Steuerungen; DIN-Tragschienenadapter zum Aufnehmen eines Leitungsschutzschalters, Motorstarters oder Phasenwächters; Motorstarter; Schalter für ohmsche Verbraucher; Lasttrennschalter; und mit einem oder mehren Klemmenblöcken (600), welche an dem Adapter (500) befestigt sind.

8. Elektromechanische Baugruppe nach Anspruch 7, **dadurch gekennzeichnet, dass** wenigstens eine elektromechanische Komponente (600) mit wenigstens einem elektronischen Gerät (400) elektrisch leitend verbunden ist, insbesondere über eine Kabel- oder Leitungsverbindung (700).

## Claims

1. Connection apparatus (200) having a contact field (300) for fastening and making contact with electronic devices (400) and having an adapter (500) for receiving electromechanical components (600), wherein the contact field (300) has at least one busbar (310), wherein the busbar (310) is accommodated in a plastic housing (320) of the contact field (300), wherein the plastic housing (320) has a plurality of first passage openings (321) and second passage openings (322), wherein the first passage openings (321) are configured to plug through contacts of electronic devices (400) in order to connect the electronic devices (400) to the busbar (310) in an electrically conductive manner in a state installed on the contact field (300), wherein the adapter (500) is fastened to the contact field (300), **characterized in that** the second passage openings (322) are configured to receive fastening elements of electronic devices (400) in order to releasably connect the electronic devices (400) to the contact field (300), wherein the adapter (500) has a plastic or wherein the adapter (500) is composed of a plastic, wherein the adapter (500) does not have any electrically conductive elements for making contact with and/or connecting electromechanical components (600) or electronic devices (400), and wherein the adapter (500) is configured to fasten terminal blocks (600).

2. Connection apparatus according to Claim 1, **characterized in that** the contact field (300) has a fitting plane (330), in the region of which electronic devices (400) are arranged on the contact field (300), **in that** the contact field (300) has a fastening side (340), in the region of which the contact field (300) can be connected to a switchgear cabinet or to a structure carrying the contact field (300), wherein the fastening side (340) faces away from the fitting plane (330), and **in that** the adapter (500) is arranged, at least in sections, in the region of an edge side (360) of the contact field (300) that is arranged between the fastening side (340) and the fitting plane (330).

3. Connection apparatus according to Claim 1, **characterized in that** the adapter (500) is arranged in a manner set back from the fitting plane (330) of the contact field (300), wherein a fitting plane (510) of the adapter (500) is at a distance (A) from the fitting plane (330) of the contact field (300) when seen along an insertion direction (E) for installing electronic devices (400) and/or electromechanical components (600).

4. Connection apparatus according to one of Claims 1 to 3, **characterized in that** the adapter (500) is mechanically latched to the contact field (300).

5. Connection apparatus according to one of Claims 1 to 4, **characterized in that** the contact field (300) has a profile (350) for fastening the contact field (300) to a top-hat rail.

6. Connection apparatus according to one of Claims 1 to 5, **characterized in that** a contact spacing (R) of the passage openings (321, 322) is 4.5 mm.

7. Electromechanical assembly (100) having a connection apparatus (200) according to one of the preceding Claims 1 to 6, having one or more of the electronic devices (400) which are mentioned below and are fastened to the contact field (300) : a supply module for applying a supply voltage; a power supply module for supplying voltage to one or more controllers; a DIN mounting rail adapter for receiving a circuit breaker, a motor starter or a phase monitor; a motor starter, a switch for resistive loads; a switch disconnector; and having one or more terminal blocks (600) which are fastened to the adapter (500).

8. Electromechanical assembly according to Claim 7, **characterized in that** at least one electromechanical component (600) is connected to at least one electronic device (400) in an electrically conductive manner, in particular via a cable or line connection (700).

## Revendications

1. Dispositif de connexion (200), comprenant un champ de contact (300) permettant de fixer et d'établir un contact avec des appareils électroniques (400) et comportant un adaptateur (500) permettant de recevoir des composants électromécaniques (600), le champ de contact (300) comprenant au moins une barre omnibus (310), la barre omnibus (310) étant logée dans un boîtier en matière plastique (320) du champ de contact (300), le boîtier en matière plastique (320) comprenant une pluralité de premières ouvertures traversantes (321) et de secondes ouvertures traversantes (322), les premières ouvertures traversantes (321) étant conçues pour insérer des contacts de dispositifs électroniques (400) afin de connecter électriquement les dispositifs électroniques (400) à la barre omnibus (310) dans un état monté sur le champ de contact (300), l'adaptateur (500) étant fixé au champ de contact (300),
**caractérisé en ce que** les secondes ouvertures traversantes (322) sont conçues pour recevoir des éléments de fixation de dispositifs électroniques (400) afin de connecter de manière amovible les dispositifs électroniques (400) au champ de contact (300), l'adaptateur (500) comprenant une matière plastique ou l'adaptateur (500) étant constitué d'une matière plastique, l'adaptateur (500) ne comprenant pas d'éléments électriquement conducteurs permettant d'établir un contact et/ou de connecter des composants électromécaniques (600) ou des appareils électroniques (400), et l'adaptateur (500) étant conçu pour fixer des borniers (600).

2. Dispositif de connexion selon la revendication 1, **caractérisé en ce que** le champ de contact (300) présente un plan d'équipement (330) dans la zone duquel des appareils électroniques (400) sont disposés sur le champ de contact (300), **en ce que** le champ de contact (300) présente un côté de fixation (340) dans la zone duquel le champ de contact (300) peut être relié à une armoire électrique ou à une structure portant le champ de contact (300), le côté de fixation (340) étant orienté à l'opposé du plan d'équipement (330), et **en ce que** l'adaptateur (500) est disposé au moins par sections dans la zone d'un côté de bord (360) du champ de contact (300) disposé entre le côté de fixation (340) et le plan d'équipement (330) .

3. Dispositif de connexion selon la revendication 1, **caractérisé en ce que** l'adaptateur (500) est disposé en retrait par rapport au plan d'équipement (330) du champ de contact (300), un plan d'équipement (510) de l'adaptateur (500), vu suivant une direction d'insertion (E) destinée au montage d'appareils électroniques (400) et/ou de composants électromécaniques (600), présentant une distance (A) par rapport au plan d'équipement (330) du champ de contact (300).

4. Dispositif de connexion selon l'une des revendications 1 à 3, **caractérisé en ce que** l'adaptateur (500) est encliqueté mécaniquement dans le champ de contact (300).

5. Dispositif de connexion selon l'une des revendications 1 à 4, **caractérisé en ce que** le champ de contact (300) comprend un profilé (350) permettant de fixer le champ de contact (300) à un rail DIN.

6. Dispositif de connexion selon l'une des revendications 1 à 5, **caractérisé en ce qu'**une dimension modulaire (R) des ouvertures traversantes (321, 322) est de 4,5 mm.

7. Ensemble électromécanique (100), comprenant un dispositif de connexion (200) selon l'une des revendications 1 à 6 précédentes, comprenant un ou plusieurs des appareils électroniques (400) mentionnés ci-après, qui sont fixés au champ de contact (300) : un module d'alimentation permettant d'appliquer une tension d'alimentation ; un module adaptateur secteur permettant d'alimenter en tension un ou plusieurs éléments de commande ; un adaptateur de rail DIN permettant de recevoir un disjoncteur, un démarreur de moteur ou un contrôleur de phase ; un démarreur de moteur ; un commutateur pour consommateurs ohmiques ; un commutateur-sectionneur ; et comprenant un ou plusieurs borniers (600) qui sont fixés à l'adaptateur (500).

8. Ensemble électromécanique selon la revendication 7, **caractérisé en ce qu'**au moins un composant électromécanique (600) est relié de manière électriquement conductrice à au moins un appareil électronique (400), notamment par l'intermédiaire d'une liaison par câble ou par ligne (700).
